Europäisches Patentamt

European Patent Office

Office européen des brevets

(19)

(11) **EP 1 376 143 A2**

(12) **EUROPEAN PATENT APPLICATION**

(43) Date of publication:
**02.01.2004 Bulletin 2004/01**

(51) Int Cl.⁷: $G01R\ 31/00$

(21) Application number: **03000808.0**

(22) Date of filing: **14.01.2003**

(84) Designated Contracting States:
**AT BE BG CH CY CZ DE DK EE ES FI FR GB GR HU IE IT LI LU MC NL PT SE SI SK TR**
Designated Extension States:
**AL LT LV MK RO**

(30) Priority: **18.06.2002 JP 2002176540**

(71) Applicant: **Hitachi, Ltd.**
**Chiyoda-ku, Tokyo 101-8010 (JP)**

(72) Inventors:
• **Uesaka, Kouichi, Hitachi, Ltd., Intellec.Prop.Dep.**
**Tokyo 100-8220 (JP)**
• **Aiuchi, Susumu, Hitachi, Ltd.,**
**Intellect.Prop.Dep.**
**Tokyo 100-8220 (JP)**
• **Noma, Tatsuji, Hitachi, Ltd., Intellect.Prop.Dep.**
**Tokyo 100-8220 (JP)**

(74) Representative: **Strehl Schübel-Hopf & Partner**
**Maximilianstrasse 54**
**80538 München (DE)**

(54) **Apparatus for displaying the distribution of an electric property of an electronic appliance**

(57) An electronic appliance displaying apparatus that, by implementing the following views, makes it possible to identify a wire, a component, or the like that generates an electromagnetic field. At first, the displaying apparatus derives electric-current distribution (203), electric-voltage distribution, electric-power distribution, or impedance distribution from magnetic-field distribution or electric-field distribution existing in vicinities of an electronic appliance, i.e., a target to be measured. Next, the displaying apparatus superposition-displays (201,601,1201) at least one of the above-described distributions on an image of the electronic appliance, CAD data thereon, layout data thereon, or circuit diagram thereof (202,502,1102). Otherwise, the displaying apparatus displays, on plural views (301,801,1401), at least one of the distributions and the latter data (202,502,1102).

## FIG. 2

EP 1 376 143 A2

**Description**

BACKGROUND OF THE INVENTION

The present invention relates to an electronic appliance displaying apparatus for identifying and displaying a generating source of electromagnetic-wave noises radiated from an electronic appliance, an electronic appliance designed to reduce the electromagnetic-wave noises radiated therefrom, and a manufacturing method thereof.

Conventionally, after measuring magnetic-field distribution existing in proximity to semiconductors, a circuit board, and an electronic appliance using therein the semiconductors and the circuit board, this magnetic-field distribution has been displayed, or has been projected on an image of the electronic appliance.

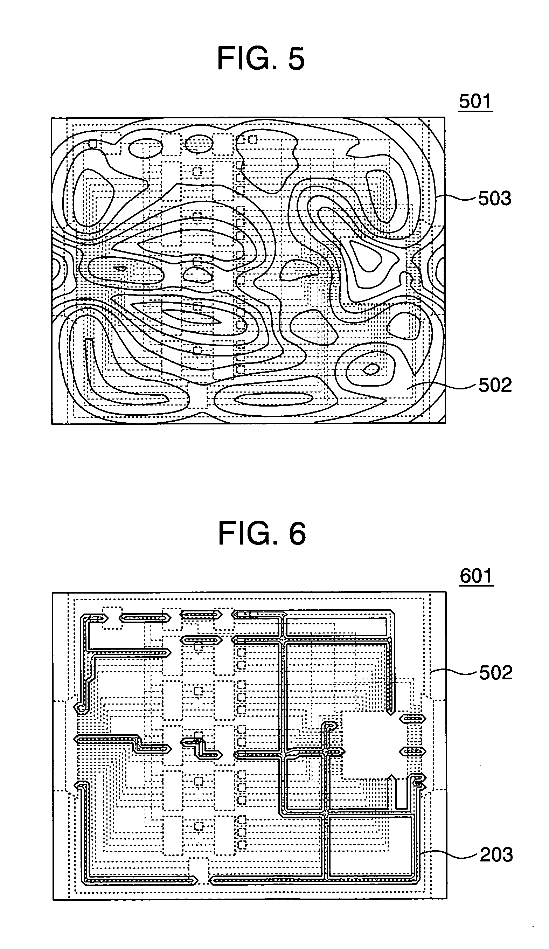

For example, in JP-A-2000-019204, magnetic-field distribution of a circuit board, i.e., a target to be measured, has been measured using an antenna probe. Then, as illustrated in FIG. 5, a measured result (i.e., a magnetic-field distribution contour-line diagram 503) has been displayed superposingly (i.e., superposition display 501) on a circuit board image 502.

SUMMARY OF THE INVENTION

In this method, however, magnetic field existing at a height $z = h$ from wires through which electric current flows is measured and displayed without measuring and displaying the electric current itself, i.e., a generating factor. This condition causes a spread to occur in the obtained magnetic-field distribution, thereby resulting in a problem that it is impossible to identify a generating source of electromagnetic-wave noises on each wire or component basis. On account of this, in the method of manufacturing an electronic appliance designed to reduce electromagnetic-wave noises therefrom, it becomes required to provide another step of identifying an electromagnetic-wave noise generating source on each wire or component basis.

Also, there exists a problem that the superposition display results in bad visibility if there exist many measurement locations on a target to be measured, if measured magnetic-field distribution is complicated, or if it is wished to confirm the to-be-measured target in a 3-dimentional manner.

Accordingly, in the present invention, it is selected as an object thereof to provide an electronic appliance displaying apparatus that is capable of identifying a generating source of electromagnetic-wave noises on each wire or component basis inside an electronic appliance.

Also, another object of the present invention is to provide an electronic appliance designed to reduce electromagnetic-wave noises therefrom, and an electronic appliance manufacturing method that allows speeding-up and simplification of a step of improving the electronic appliance that generates electromagnetic-wave noises.

Of the inventions that will be disclosed in the present application in order to accomplish at least one of the above-described objects, representative invention will be explained briefly as follows:

(1) An electronic appliance displaying apparatus for deriving electric-current distribution from magnetic-field distribution existing in proximity to an electronic appliance, and for displaying the electric-current distribution, wherein the electric-current distribution of the electronic appliance is separation-displayed on each layer basis.

(2) An electronic appliance manufacturing method including a first step of measuring magnetic-field distribution of an electronic appliance, a second step of identifying an electromagnetic-wave noise generating source from measured magnetic-field distribution, and a third step of improving the electronic appliance on the basis of identification of the electromagnetic-wave noise generating source,

wherein, at least at one of the above-described steps, at least one of the electric-current distribution, the electric-voltage distribution, the electric-power distribution, and the impedance distribution is derived from the above-described magnetic-field distribution, and the derived distribution is superposition-displayed on a screen showing an image of the electronic appliance, CAD data thereon, layout data thereon, or a circuit diagram thereof.

(3) An electronic appliance designed to reduce electromagnetic-wave noises therefrom,

wherein, at a step of identifying a generating source of electromagnetic-wave noises, at least one of electric-current distribution, electric-voltage distribution, electric-power distribution, and impedance distribution is derived from magnetic-field distribution existing in proximity to the electronic appliance, and the derived distribution is superposition-displayed on a screen showing an image of the electronic appliance, CAD data thereon, layout data thereon, or circuit diagram thereof.

Other objects, features and advantages of the invention will become apparent from the following description of the embodiments of the invention taken in conjunction with the accompanying drawings.

BRIEF DESCRIPTION OF THE DRAWINGS

FIG. 1 is a diagram for illustrating a measuring system;
FIG. 2 is a diagram for illustrating in-LSI electric-current distribution by superposition;
FIG. 3 is a diagram for illustrating in-LSI electric-current distribution by plural-picture;

FIG. 4 is a diagram for illustrating in-LSI electric-current distribution by plane-separation;

FIG. 5 is a diagram for illustrating on-circuit-board electromagnetic-field distribution by superposition;

FIG. 6 is a diagram for illustrating on-circuit-board electric-current distribution by superposition;

FIG. 7 is a diagram for illustrating on-circuit-board electromagnetic-field distribution by plural-picture;

FIG. 8 is a diagram for illustrating on-circuit-board electric-current distribution by plural-picture;

FIG. 9 is a diagram for illustrating on-circuit-board electromagnetic-field distribution by plane-separation;

FIG. 10 is a diagram for illustrating on-circuit-board electric-current distribution by plane-separation;

FIG. 11 is a diagram for illustrating on-housing-surface electromagnetic-field distribution by superposition;

FIG. 12 is a diagram for illustrating on-housing-surface electric-current distribution by superposition;

FIG. 13 is a diagram for illustrating on-housing-surface electromagnetic-field distribution by plural-picture;

FIG. 14 is a diagram for illustrating on-housing-surface electric-current distribution by plural-picture;

FIG. 15 is a diagram for illustrating on-housing-surface electromagnetic-field distribution by plane-separation;

FIG. 16 is a diagram for illustrating on-housing-surface electric-current distribution by plane-separation;

FIG. 17 is a diagram for illustrating microstrip line electric-current distribution by frequency-characteristic;

FIG. 18 is a diagram for illustrating microstrip line electric-current distribution by time-characteristic;

FIG. 19 is a diagram for illustrating microstrip line electric-current distribution by layer-separation;

FIG. 20 is a diagram for illustrating a mode of plural views;

FIG. 21 is a diagram for a illustrating a mode of plural views; and

FIG. 22 is a diagram for illustrating electric-current distribution by plural views before and after improvement.

## DETAILED DESCRIPTION OF THE EMBODIMENTS

Hereinafter, with co-use of the drawings, specific explanation will be given below concerning an embodiment of the present invention.

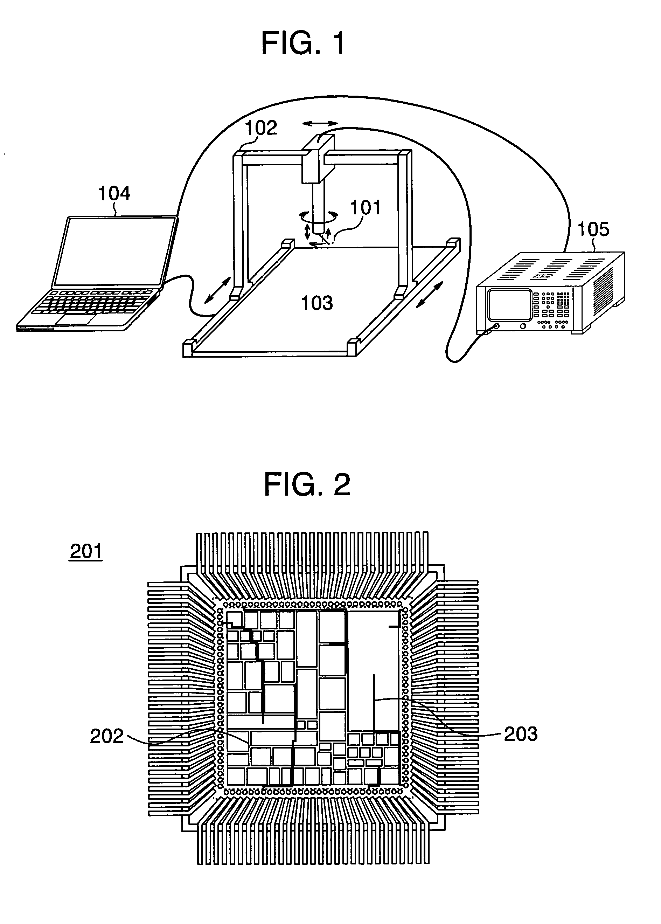

Measuring operation by a measuring system illustrated in FIG. 1 is as follows: First, an antenna probe 101 is attached to a scanning system stage 102, and an electronic appliance including semiconductors and a circuit board is mounted on a base 103. Next, using the scanning system stage 102, the antenna probe 101 is displaced to vicinities of a target to be measured. Moreover, a measuring instrument 105 measures proximity magnetic-field distribution or proximity electric-field distribution at the time when the to-be-measured target is under operation. Finally, a display apparatus-equipped computer 104 reads in measured data 503. An image of the target, CAD data thereon, layout data thereon, or data on the circuit diagram thereof are stored in advance into this display apparatus-equipped computer 104. Otherwise, a camera may be mounted on the scanning system stage 102, then fetching, into the computer 104, the images photographed by the camera.

Incidentally, the term "proximity" or "vicinity" employed in the present invention refers to a distance range ranging up to a wavelength (i.e., $\lambda = c/f_{max}$) that is more distant than a to-be-measured target itself (i.e., 0 cm) and that is determined by an upper-limit (i.e., $f_{max}$) of the frequency to be measured.

For example, if the frequency band to be measured falls within 30 MHz to 1 GHz, the upper-limit is equal to 1 GHz, thus leading to $\lambda = 3E8/1E9 = 30$ cm. Also, if the frequency to be measured is a single frequency and is equal to 30 MHz, $f_{max} = 30$ MHz is given, thus leading to $\lambda = 30E6/1E9 = 10$ cm.

From the above-described measured data 503, within the display apparatus-equipped computer 104, electric-current distribution i $(xi, yi)$: 203 is calculated which permits the following relation:

$$H (xh, yh, zh) = f \{i (xi, yi, zi) \} \mid r = \sqrt{\{(xh-xi)^2}$$

$$+ (yh-yi)^2 + (zh-zi)^2\}$$

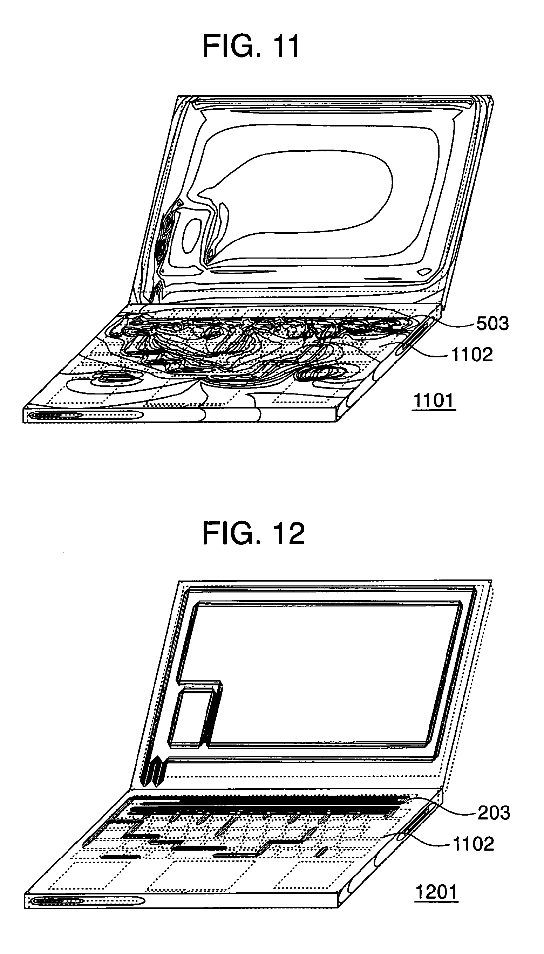

to hold precisely or approximately. Then, the electric-current distribution is superposition-displayed on the circuit board illustrated in FIG. 6. This makes it possible to recognize, on each wire or component basis, an electric-current path that becomes a generating factor of electromagnetic-wave noises. Similarly, concerning the semiconductors, as illustrated in FIG. 2, electric-current distribution 203 calculated in the same way as described above is superposition-displayed 201 on an image thereof, CAD data thereon, layout data thereon, or data on the circuit diagram thereof 202. This makes it possible to recognize an electric-current path. Moreover, regarding an electronic appliance housing, as illustrated in FIG. 12, electric-current distribution 203 calculated in the same way is superposition-displayed 1201 on an image thereof, CAD data thereon, layout data thereon, or data on the circuit diagram thereof 1102. This makes it possible to recognize an electric-current path or on-housing-surface electric-current distribution. By the way, similarly with respect to an electronic appliance housing, FIG. 11 superposition-displays 1101 electromagnetic-field distribution 503. Making comparison between FIG. 12 and FIG. 11 clearly shows the effect.

Here, in the superposition display, searched-for result is superposed on an image of the to-be-measured target, CAD data thereon, layout data thereon, or circuit diagrams thereof. As a result, the superposition display may become difficult to observe. In view of this situation, the following display can be considered: The image of the to-be-measured target, the CAD data thereon, the layout data thereon, or the circuit diagram thereof may be displayed on a black-and-white view or on its gray-scale view, while the electric-current distribution may be color-coded on each intensity basis.

Next, there exists a problem that use of the superposition display finds it difficult to perform recognition if there exist many measurement locations on a to-be-measured target, or if searched-for electric-current distribution is complicated.

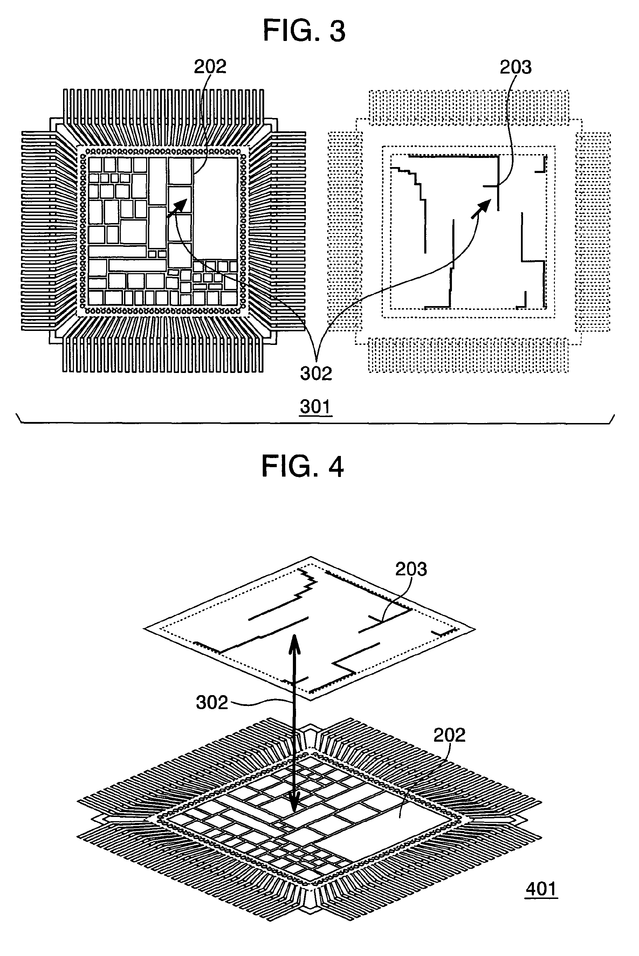

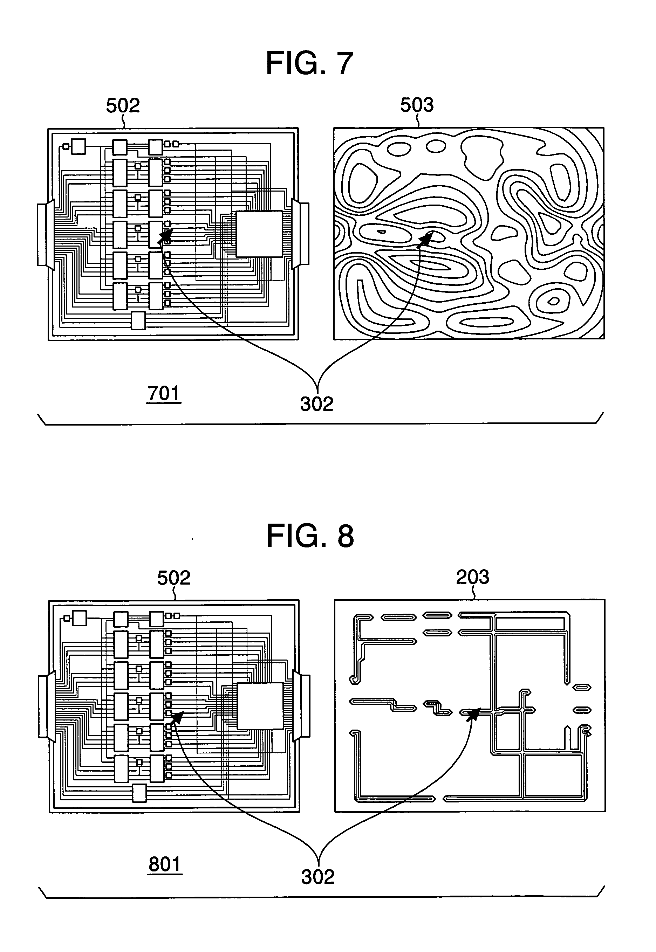

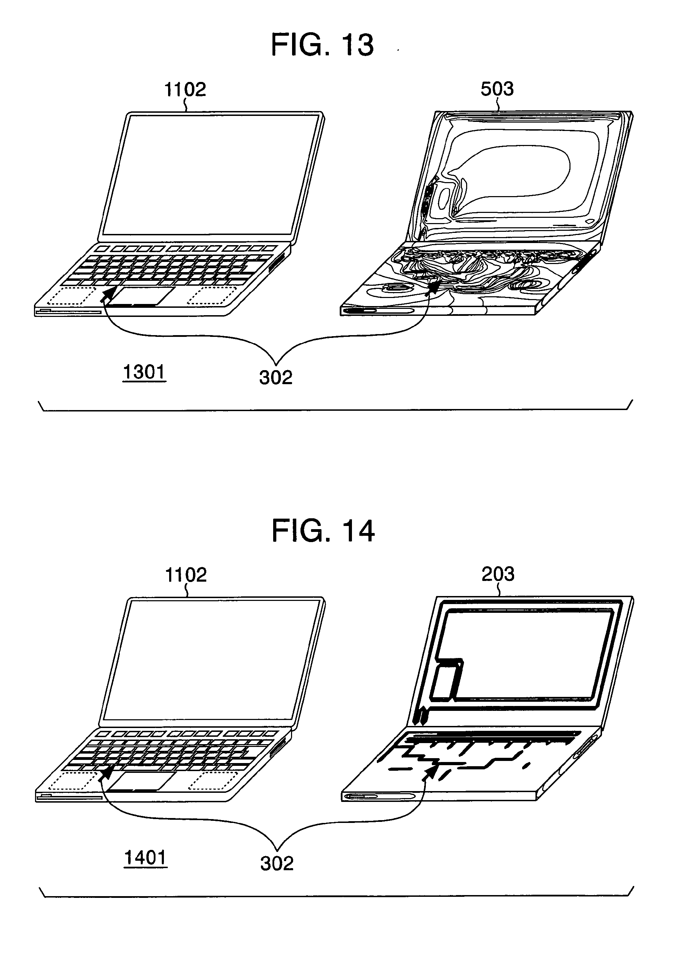

Accordingly, as illustrated in FIG. 8, it can be considered that the image of the to-be-measured target, the CAD data thereon, the layout data thereon, or the circuit diagram thereof 502, and the electric-current distribution 203, i.e., the searched-for result, may be displayed on plural views. Although FIG. 8 illustrates an example of the circuit board, basically the same display is also possible in a case of LSI illustrated in FIG. 3 or in a case of a housing illustrated in FIG. 14. Additionally, in the plural views, the distribution to be displayed is not limited to the electric-current distribution. Namely, it is needless to say that basically the same effect can also be obtained even if distribution to be displayed is electromagnetic-field distribution as illustrated in FIG. 7 or FIG. 13.

Here, the image of the to-be-measured target, the CAD data thereon, the layout data thereon, or the circuit diagram thereof 202, 502, and the electric-current distribution 203, i.e., the searched-for result, are displayed on the different views. This condition gives rise to a problem that a position on the electric-current distribution and a position on the image of the to-be-measured target, the CAD data thereon, the layout data thereon, or the circuit diagram thereof cannot be recognized in a state of coinciding with each other. Setting up an identical-coordinate display pointer 302 can eliminate this problem. This pointer 302 functions so that a coordinate on the image of the to-be-measured target, the CAD data thereon, the layout data thereon, or the circuit diagrams thereof and the coordinate on the electric-current distribution, i.e., the searched-for result, will indicate positions identical to each other. In this way, employment of the plural views allows plural distributions to be seen simultaneously in a high-visibility manner, thereby making it possible to provide the apparatus and the method having higher utilization.

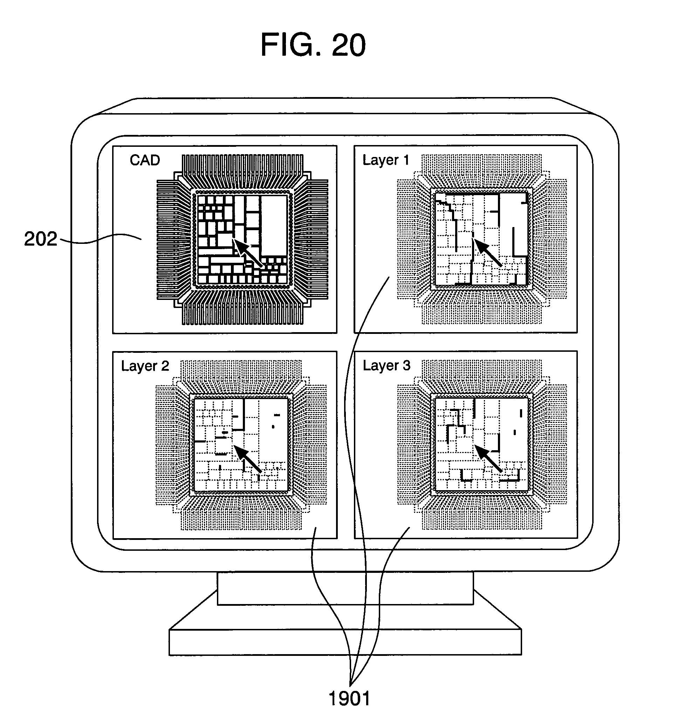

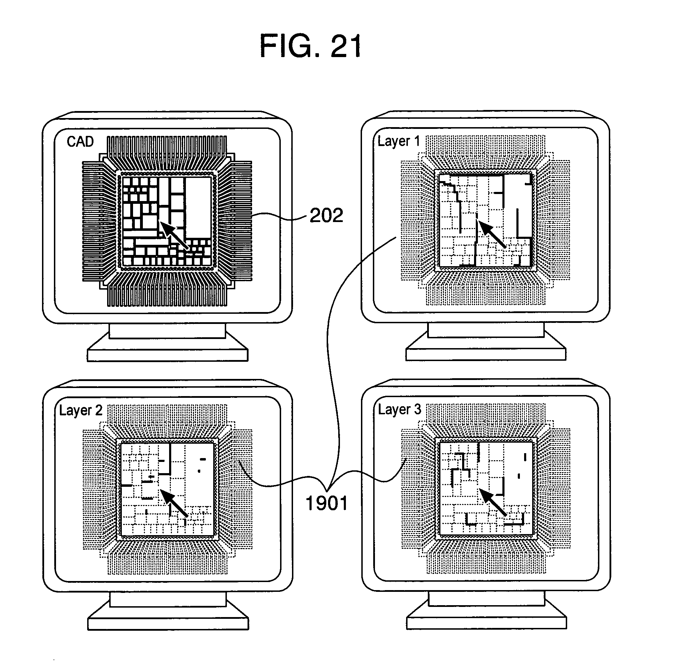

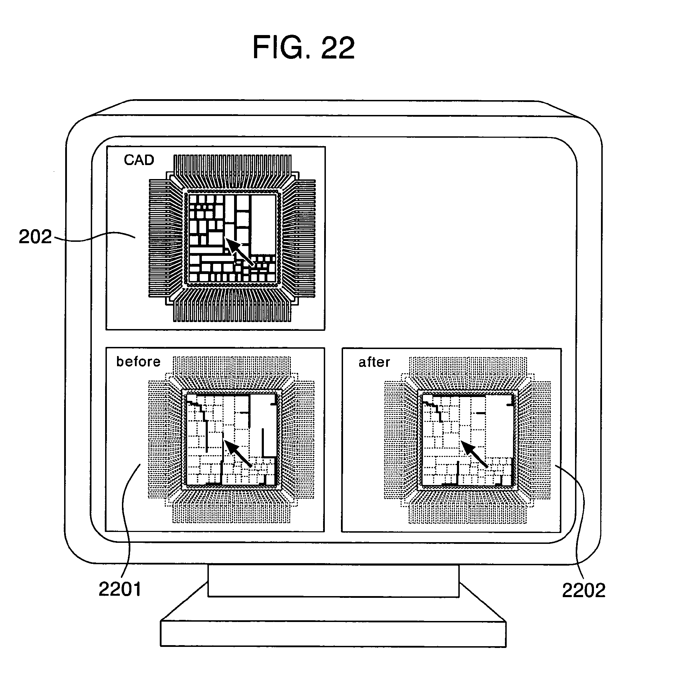

Incidentally, in order to configure the above-described plural views, it is allowable to employ a mode where, as illustrated in FIG. 20, plural views are displayed on a single-screen apparatus, or a mode where, as illustrated in FIG. 21, there are employed plural screen apparatuses. Also, the targets to be displayed on the plural views may be whatever combination of the image of the to-be-measured target, the CAD data thereon, the layout data thereon, or the circuit diagram thereof, and the measured and searched-for electric-current distribution. Otherwise, as illustrated in FIG. 22, electric-current distributions before and after improvement may be displayed at the same time.

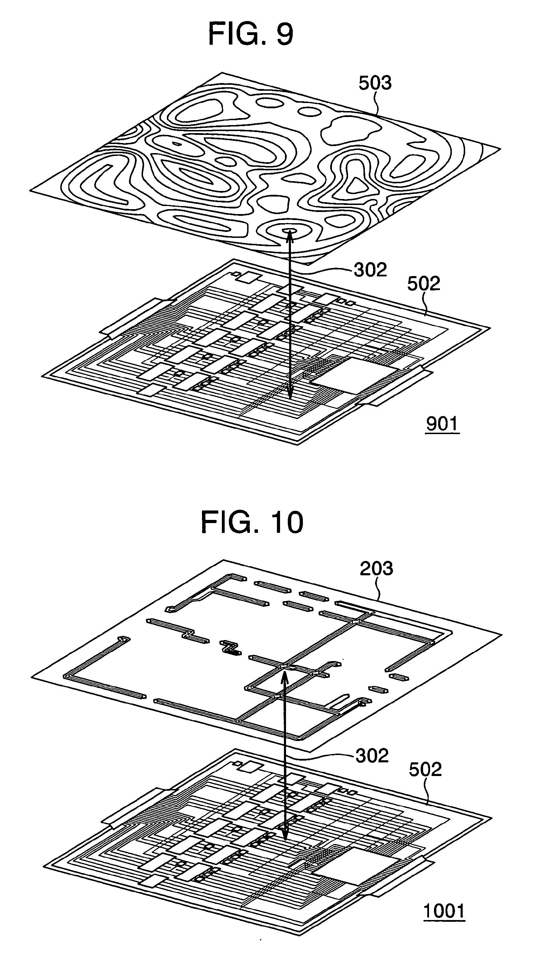

In the display method by the above-described identical-coordinate display pointer, it is possible to recognize a position projected onto a plane in a cubic-structure housing or the like. Difficulty, however, arises when wishing to confirm a to-be-measured target in a 3-dimentional manner. Accordingly, as illustrated in FIG. 10, the following display can be considered: A plane on which there are displayed the image of the to-be-measured target, the CAD data thereon, the layout data thereon, or the circuit diagram thereof 502, and a plane on which there is displayed the electric-current distribution 203, i.e., the searched-for result, may be displayed in a state of being separated from each other (e.g., by being displaced in parallel).

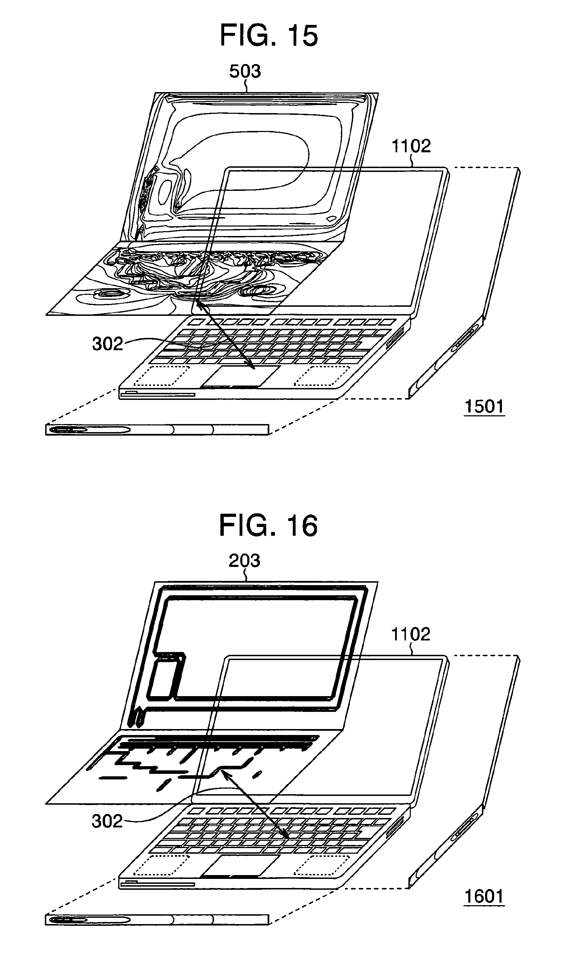

Although FIG. 10 illustrates an example of the circuit board, similar display is also possible in a case of LSI illustrated in FIG. 4 or in a case of a housing illustrated in FIG. 16. Additionally, in this plane-separation view, distribution to be displayed is not limited to electric-current distribution. Namely, it is needless to say that a similar effect can also be obtained even if distribution to be displayed is electromagnetic-field distribution as illustrated in FIG. 9 or FIG. 15.

So far, explanation has been given mainly concerning the following case: Magnetic-field distribution existing in vicinities of a to-be-measured target is measured, then determining electric-current distribution from the magnetic-field distribution. A similar display method, however, can also be considered in the following case: Electric-field distribution existing in vicinities of a to-be-measured target is measured, then determining electric-voltage distribution from the electric-field distribution in accordance with the following expression:

$$E(x_h, y_h, z_h) = g\{V(x_i, y_i, z_i)\} \mid r = \sqrt{\{(x_h-x_i)^2 + (y_h-y_i)^2 + (z_h-z_i)^2\}}.$$

Moreover, both the electric-current distribution and the electric-voltage distribution existing on the to-be-measured target can also be determined through the calculation from the magnetic-field distribution and the electric-field distribution in vicinities of the to-be-measured target.

Further, if both the electric-current distribution and the electric-voltage distribution have been determined, electric-power distribution and impedance distribution on the to-be-measured target, which are applicable to the above-described display method, can be determined in accordance with the following expressions:

$$P (x, y, z) = i (x, y, z) \times V (x, y, z)$$

$$Z (x, y, z) = V (x, y, z) / i (x, y, z) .$$

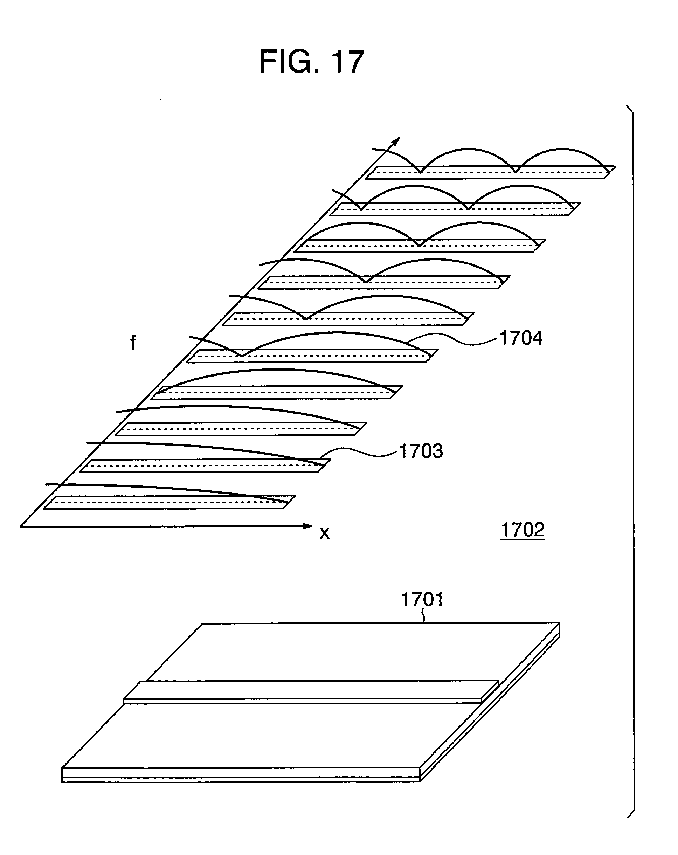

Still further, the target proximity magnetic field is measured as frequency characteristic, then calculating electric-current distribution for each frequency. This allows the electric-current distribution to be displayed on a frequency-characteristic view as is illustrated in FIG. 17. FIG. 17 illustrates results obtained in a case where electric current including plural frequency components has flown on a microstrip line 1701 whose terminal-ends are open. Electric-current distribution waveform 1704 on each frequency basis, which has been distributed over conductor 1703, is an example 1702 of this view on each frequency basis.

Also, the to-be-measured-target proximity magnetic field is measured as time characteristic so as to calculate time characteristic of electric-current distribution, then transforming this time characteristic into frequency characteristic by using Fourier transformation. This allows electric-current distribution to be displayed on a frequency-characteristic view as is illustrated in FIG. 17.

Concerning the method of displaying the above-described frequency characteristic as well, proximity magnetic-field distribution or proximity electric-field distribution is selected as a target to be measured, then calculating electric-current distribution, electric-voltage distribution, electric-power distribution, or impedance distribution. This allows each of electric-current distribution, electric-voltage distribution, electric-power distribution, and impedance distribution to be displayed on each frequency-characteristic view.

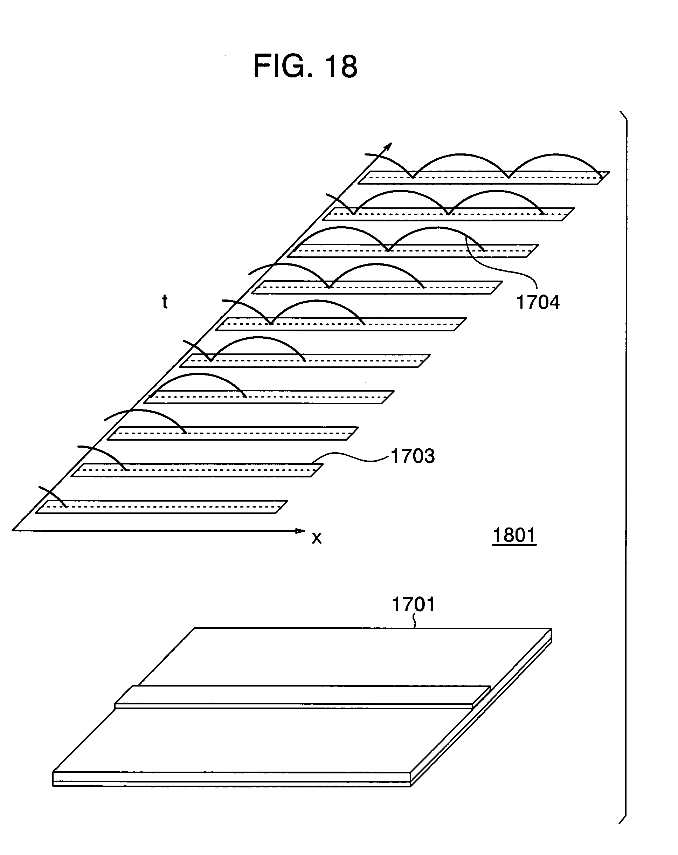

Furthermore, the target proximity magnetic field is measured as time characteristic, then calculating time characteristic 1704 of electric-current distribution. This allows electric-current distribution to be displayed on a time-characteristic view as is illustrated in FIG. 18. FIG. 18 illustrates the microstrip line 1701 whose terminal-ends are open, and a time-characteristic view 1801 in a case where electric current starts to flow on the microstrip line 1701. Electric-current distribution waveform 1704 on each time basis has been distributed on the conductor 1703. As is seen from the distribution waveform 1704, the time-characteristic view makes it possible not only to identify electromagnetic-wave noise generating source on each wire or component basis, but also to identify and improve a discontinuous point, i.e., one of the causes for generation of electromagnetic-wave noises.

Regarding the above-described display method in correspondence with time as well, proximity magnetic-field distribution or proximity electric-field distribution is selected as a target to be measured, then calculating electric-current distribution, electric-voltage distribution, electric-power distribution, or impedance distribution. This allows each of the electric-current distribution, the electric-voltage distribution, the electric-power distribution, and the impedance distribution to be displayed on each time-characteristic view.

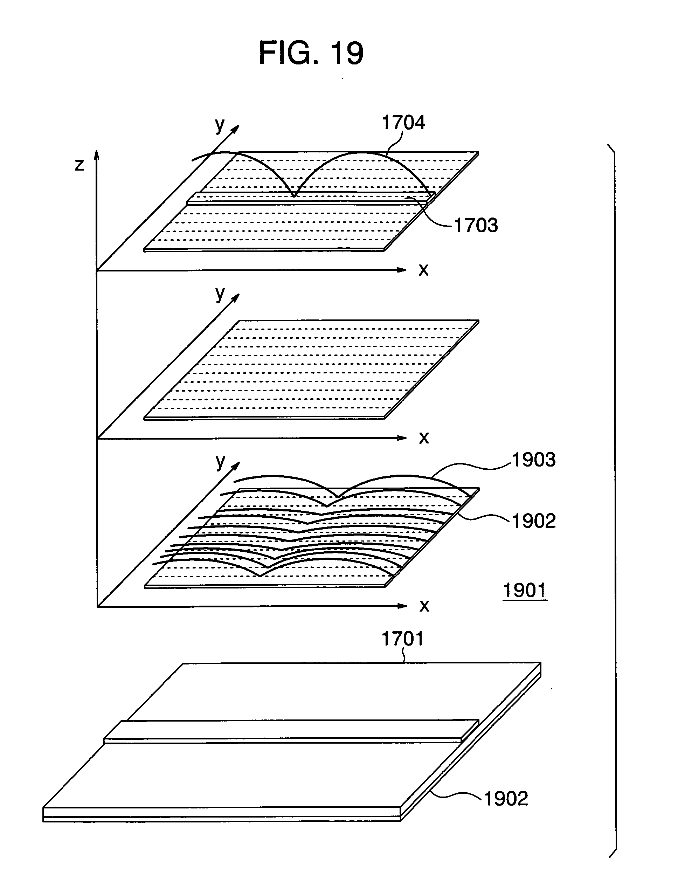

Also, an example illustrated in FIG. 19 is results obtained by determining electric-current distribution on each layer basis from proximity magnetic-field distribution with respect to the microstrip line 1701. The results show the following: Supplied electric-current distribution 1704 flows in the upper-most layer, i.e., the conductor 1703. There exists no electric current in the intermediate layer, i.e., a dielectric portion. Return electric current 1903 flows in the lower-most layer, i.e., the ground plane 1902.

In this way, in the following apparatus, it becomes possible to determine positions in a 3-dimentional manner as a multi-layer structure of 2-dimentional planes, and to display, on each layer basis, distributions, frequency characteristics, or time characteristics for these respective planes: The apparatus measures the magnetic-field distribution or the electric-field distribution in proximity to the above-described target so as to calculate, from the data measured, at least one of electric-current distribution, the electric-voltage distribution, the electric-power distribution, and the impedance distribution, then displaying the frequency characteristic or the time characteristic thereof.

Incidentally, co-use of the above-described views, e.g., the superposition view, the plural-picture view, the plane-separation view, the view on each layer basis, on each plane basis, or on each structure basis, the view with frequency variation, or the view with time variation, makes it possible to provide an electronic appliance displaying apparatus having even higher visibility and even higher utilization.

Also, utilization of the above-described distributions and the above-described views makes it possible to provide an electronic appliance designed to reduce electromagnetic-wave noises therefrom, and an electronic appliance manufacturing method that allows speeding-up and simplification of a step of improving the electronic appliance that generates electromagnetic-wave noises.

So far, based on the above-described embodiments, specific explanation has been given regarding the present invention. It is needless to say, however, that the present invention is not limited to the embodiments, but is amendable in various ways within the scope without departing from its spirit.

A representative one out of the inventions that have been disclosed in the present application makes it possible to obtain at least any one of the following effects:

(1) Allowing the generating source of electromagnetic field to be identified on each wire or component basis with a resolution higher than conventional one,

(2) allowing a view to be implemented in a high-visibility manner if there exist many measurement locations on a to-be-measured target, if measured magnetic-field distribution is complicated, or if it is wished to confirm the to-be-measured target in a 3-dimensional manner,

(3) allowing identification and improvement of a discontinuous point on a wire, i.e., one of causes for electromagnetic-field noise generation,

(4) allowing the electric-current distributions before and after improvement to be displayed on plural views, which makes it possible to confirm an effect after the improvement,

(5) allowing implementation of speeding-up and simplification in an electronic appliance manufacturing method including a first step of measuring magnetic-field distribution of the electronic appliance, a second step of identifying an electromagnetic-wave noise generating source from the measured magnetic-field distribution, and a third step of improving the electronic appliance on the basis of identification of the electromagnetic-wave noise generating source, and

(6) allowing mass production of an electronic appliance, which is designed to reduce electromagnetic-wave noises therefrom, on the basis of speeding-up and simplification of the manufacturing method mentioned in the above-described (5).

It should be further understood by those skilled in the art that although the foregoing description has been made on embodiments of the invention, the invention is not limited thereto and various changes and modifications may be made without departing from the spirit of the invention and the scope of the appended claims.

## Claims

1. An electronic appliance displaying apparatus for displaying at least one of electric-current distribution (203, 203, 203), electric-voltage distribution, electric-power distribution, and impedance distribution that are derived from magnetic-field distribution existing in vicinities of an electronic appliance, wherein, said derived distribution is superposition-displayed (201, 601, 1201) on an image of said electronic appliance, CAD data thereon, layout data thereon, or a circuit diagram thereof (202, 502, 1102).

2. The electronic appliance displaying apparatus as claimed in claim 1, wherein, in performing the superposition display (201, 601, 1201), said target to be measured is displayed on a black-and-white display or on its gray-scale display.

3. The electronic appliance displaying apparatus as claimed in claim 1, wherein said distribution is displayed on a view (1702) implemented in correspondence with frequency variation.

4. The electronic appliance displaying apparatus as claimed in claim 1, wherein said distribution is displayed on a view (1801) implemented in correspondence with time variation.

5. The electronic appliance displaying apparatus as claimed in claim 1, wherein said distribution is displayed on a view (1901) varied for each cross-section of said electronic appliance.

6. An electronic appliance displaying apparatus for displaying magnetic-field distribution existing in vicinities of an electronic appliance, wherein said magnetic-field distribution, and an image of said electronic appliance, CAD data thereon, layout data thereon, or a circuit diagram thereof (202, 502, 1102) are displayed on plural views (301, 801, 1401).

7. The electronic appliance displaying apparatus as claimed in claim 6, wherein pointers for indicating an identical coordinate are displayed on said view displaying said magnetic-field distribution, and on said view displaying said image of said electronic appliance, said CAD data thereon, said layout data thereon, or the circuit diagram thereof (202, 502, 1102).

8. The electronic appliance displaying apparatus as claimed in claim 6, wherein said electronic appliance displaying apparatus derives from said magnetic-field distribution, and displays at least one of electric-current distribution (203, 203, 203), electric-voltage distribution, electric-power distribution, and impedance distribution.

9. The electronic appliance displaying apparatus as claimed in claim 8, wherein pointers for indicating an identical coordinate are displayed on said view displaying said derived distribution, and on said view displaying said image of said electronic appliance, said CAD data thereon, said layout data thereon, or said circuit diagram thereof (202, 502, 1102).

10. An electronic appliance displaying apparatus for displaying magnetic-field distribution existing in vicinities of an electronic appliance, wherein said magnetic-field distribution is separation-displayed (401, 1001, 1601) for each layer of said electronic appliance.

11. The electronic appliance displaying apparatus as claimed in claim 10, wherein said electronic appliance displaying apparatus derives from said magnetic-field distribution on each layer basis, and displays at least one of electric-current distribution (203), electric-voltage distribution, electric-power distribution, and impedance distribution.

# FIG. 1

# FIG. 2

# FIG. 3

# FIG. 4

# FIG. 5

501

503

502

# FIG. 6

601

502

203

# FIG. 7

502                          503

701                  302

# FIG. 8

502                          203

801                  302

# FIG. 9

503

302

502

901

# FIG. 10

203

302

502

1001

# FIG. 11

503
1102
1101

# FIG. 12

203
1102
1201

# FIG. 13

1102        503

1301        302

# FIG. 14

1102        203

1401        302

# FIG. 15

503

1102

302

1501

# FIG. 16

203

1102

302

1601

# FIG. 17

f

1704

1703

x

1702

1701

# FIG. 18

t

x

1704

1703

1801

1701

# FIG. 19

# FIG. 20

# FIG. 21

## FIG. 22